# EUROPEAN PATENT APPLICATION

(11) **EP 4 745 932 A1**
(43) Date of publication of application: **20.05.2026**
(21) Application number: 24213219.9
(22) Date of filing: 15.11.2024
(51) Int. Cl.: G08B 13/00, G01R 31/12

(54) **IMPROVED SECURITY MONITORING SYSTEM**

(71) Applicant: Verisure Sàrl, 1290 Versoix (CH)
(72) Inventor: PIEDBOIS, Julien, 1290 Versoix (CH); HACKETT, Nicolas, 1290 Versoix (CH)
(74) Representative: Hansson Thyresson AB

(57) **Abstract**

There is provided a method of operating a security monitoring system of a premises, the method comprising: detecting, by an electrical discharge detector of the security monitoring system, an electrical discharge in electrical wiring of the premises; determining if anyone is present in the premises; selecting one of a first action and a second action in dependence on the determination, wherein the first action is selected if it is determined that someone is present, and the second action is selected if it is determined that no one is present; and performing one of the first and second actions in dependence on the selection.

## Description

### TECHNICAL FIELD

The present invention relates to a security monitoring system for monitoring of a premises, and more particularly to a security monitoring system comprising an electrical discharge detector for detecting electrical discharges in electrical wiring of the premises, and to methods of operating the same.

### BACKGROUND

Security installations that are or include security monitoring systems for monitoring premises (e.g. a building such as a home), often referred to as alarm systems, typically provide means for detecting undesirable security or safety events and reacting to detected events. Such detection means may include presence sensors, motion sensors and/or perimeter sensors for monitoring an area of the premises and detecting an unauthorized intruder entering or moving within or around the premises. Additionally, or alternatively, the means may include fire detection means such as a smoke detector for detecting smoke likely originating from a fire inside the premises.

Such systems may be self-contained, with alarm indicators such as sirens and flashing lights that may be activated when an undesirable security or safety event is detected. Alternatively, or additionally, such systems may be linked to a remote monitoring centre where, typically, human operators manage the responses required by different alarm and notification types.

Hence, the security monitoring systems can alert a user (e.g. a homeowner) or an operator (e.g. at a remote monitoring centre or at the emergency services) that an undesirable security or safety event has occurred. Accordingly, such security monitoring systems contribute to the safety and wellbeing of occupants of the protected premises as well as safeguarding articles within the protected premises.

However, a smoke detector may only detect smoke after a fire has generated a sufficient amount of smoke. At this point in time, the occupants of the premises and/or the premises themselves (e.g. if no occupants are present in the premises) may face significant danger even if the security monitoring system alerts the occupant (e.g. by a siren), an operator and/or the emergency services.

From the above, it is understood that there is room for improvements in security monitoring systems, and the invention aims to solve or at least mitigate the above and other problems. Accordingly, embodiments of the present invention seek to provide enhanced security monitoring systems, methods and other implementations that improve the scope of such systems to address aspects of the safety and security as well as providing new functionality and methods.

### SUMMARY

The invention is defined by the appended independent claims. Additional features and advantages of the concepts disclosed herein are set forth in the description which follows, and in part will be obvious from the description, or may be learned by practice of the described technologies. The features and advantages of the concepts may be realized and obtained by means of the instruments and combinations particularly pointed out in the appended claims. These and other features of the described technologies will become more fully apparent from the following description and appended claims, or may be learned by the practice of the disclosed concepts as set forth herein.

It is an objective of embodiments to provide a security monitoring system capable of monitoring electrical wiring in a premises such that the security monitoring system may detect electrical discharges that could potentially precede electrical fires. It is a further objective of embodiments to provide a security monitoring system with an improved alertness and/or potential fire detection performance. It is a yet further objective of embodiments to provide a security monitoring system that improves the potential safety of occupants in premises that may suffer from fires caused by faulty electrical wiring. It is a yet further objective of embodiments to provide a security monitoring system that may potentially reduce the risk of people and/or animals being in immediate danger from fires caused by faulty electrical wiring.

In a first aspect, there is provided a method of operating a security monitoring system of a premises, the method comprising: detecting, by an electrical discharge detector of the security monitoring system, an electrical discharge in electrical wiring of the premises; determining if anyone is present in the premises; selecting one of a first action and a second action in dependence on the determination, wherein the first action is selected if it is determined that someone is present, and the second action is selected if it is determined that no one is present; and performing one of the first and second actions in dependence on the selection. Hence, the security monitoring system can tailor its response to a detected electrical discharge in dependence on whether anyone is present in the premises or not. Accordingly, the security monitoring system can take an appropriate action is someone is in potential danger, while potentially taking a less urgent action if no one is in immediate danger.

The presence determination may be performed in dependence on the detection of the electrical discharge. Alternatively, or additionally, presence determination may already have been performed prior to (e.g. shortly before) the electrical discharge is detected.

The first action may include starting an alarm indicator in the premises and/or notifying emergency services. Hence, people present in the premises and/or emergency services are appropriately alerted that a potential fire may start in the premises as a result of the faulty electrical wiring causing the electrical discharge. The second action, on the other hand, may include: altering a sensor state of one or more sensors of the security monitoring system, and/or monitoring the premises by one or more sensors of the security monitoring system, and/or sending a notification to a device, and/or contacting a person associated with the premises, and/or notifying a remote monitoring centre. Hence, the security monitoring system can take action without unnecessarily contacting the emergency services.

The device to which a notification may be sent may be a control unit of the security monitoring system, a device of a remote monitoring centre, a user device (e.g. of an individual associated with the premises such as an occupant or owner), and/or a server associated with a web portal or the like.

Optionally, the step of determining if anyone is present in the premises comprises inferring the presence from one or more security states of the security monitoring system. The security states may comprise any one or more of: an armed or disarmed state of the security monitoring system, a locked or unlocked state of one or more electronic door locks of the security monitoring system, and a state of one or more perimeter sensors indicating that a door or window is open or closed. Optionally, the method further comprises determining that someone is present if at least one of the security states infers presence. The security state(s) are typically known by the security monitoring system, and/or be quickly determined by the security monitoring system, thus ensuring a fast response to the detected electrical discharge.

Alternatively, or additionally, the step of determining if anyone is present in the premises comprises detecting the presence by one or more sensors of the security monitoring system. The one or more sensors may comprise any one or more of: a presence sensor, a radiation-based sensor, an infrared sensor, a passive infrared sensor, a motion sensor, a photosensor, a temperature sensor, a shock sensor, a sound sensor, and/or an image capturing sensor. Hence, the security monitoring system can advantageously utilise its already present sensors for a second purpose (in addition to their primary purpose of detecting an intruder). Optionally, the step of detecting the presence may comprise activating at least one of the one or more sensors and/or monitoring the premises by at least one of the one or more sensors.

Additionally, or alternatively, the method may comprise determining a time of day, and inferring presence in dependence on the time of day and typical habits of one or more occupants of the premises. The determination of the time of day may include receiving the time of day from a device (e.g. a device of the security monitoring system), such as a control unit, one or more sensors or any other device programmed with the time and/or date. Furthermore, the security monitoring system may know one or more habits or patterns of an occupant (e.g. that the occupant always leaves the premises at certain times). This may be known from typical patterns of when the user arms/disarms the security monitoring system, from typical patterns of when a sensor (e.g. a doorbell camera and/or a perimeter sensor) notices that the occupant leaves/enters the premises, from typical patterns of when a radio-based presence sensing arrangement notices when an occupant is present in one or more areas of the premises, or the like.

Optionally, at least one of the one or more sensors comprises an image capturing sensor, wherein the method optionally comprises: acquiring an image from the image capturing sensor, determining a lighting amount in the premises, determining a time of day, and inferring presence in dependence on the time of day. The security monitoring system may accordingly be configured to infer presence if the lighting amount is inconsistent with a typical (or reference) lighting amount associated with the determined time of day. For example, if the time of day is consistent with nighttime and the lighting amount is greater than a threshold amount, it may be inferred that e.g. a lamp is turned on meaning that someone is likely present in the building.

Alternatively, or additionally, the step of determining if anyone is present in the premises comprises detecting the presence by a radio-based presence sensing arrangement which may or may not be part of the security monitoring system. This is particularly advantageous if one or more devices (e.g a control unit and/or one or more sensors) of the security monitoring system function as nodes in the radio-based presence sensing arrangement. The radio-based presence sensing arrangement may be configured to detect perturbations in radio signals (e.g. Wi-Fi signals) transmitted and/or received by the radio-based presence sensing arrangement.

Alternatively, or additionally, the step of determining if anyone is present in the premises comprises determining the presence in dependence on an input from a user. Optionally, the method further comprises: transmitting a request to one or more devices, receiving an input from at least one of the devices in response to the request, and determining presence in dependence on the received input. The at least one device may include a control unit of the security monitoring system, a device of a remote monitoring centre, a user device (e.g. of an individual associated with the premises such as a tenant or owner), and/or a server associated with a web portal or the like. Optionally, the method further comprises: if no input has been received within a predetermined time period, transmitting a second request to one or more devices.

Optionally, the electrical discharge detector comprises a plug inserted into an outlet of the electrical wiring.

Optionally, the step of detecting the electrical discharge comprises: measuring an electrical signal waveform of the electrical wiring; identifying one or more transient signals within the waveform; and determining an occurrence of the electrical discharge in dependence on transient characteristics of the one or more transient signals.

In a second aspect, there is provided a security monitoring system for monitoring of a premises, the security monitoring system comprising: at least one electrical discharge detector configured to be connected to an outlet of electrical wiring in the premises, wherein the electrical discharge detector is configured to detect an electrical discharge in the electrical wiring; and at least one presence inferring means configured to infer or detect if anyone is present at the premises.

The security monitoring system may be configured to perform the method according to the first aspect.

The presence inferring means may comprise any one or more of: a presence sensor, a radiation-based sensor, an infrared sensor, a passive infrared sensor, a motion sensor, a photosensor, a temperature sensor, a shock sensor, a sound sensor, and/or an image capturing sensor. Alternatively, or additionally, the presence inferring means may comprise a radio-based presence sensing arrangement configured to detect perturbations in radio signals (e.g. Wi-Fi signals) transmitted and/or received by the radio-based presence sensing arrangement. Yet alternatively, or additionally, the presence inferring means may comprise a processor configured to process data relating to one or more security states, a time of day, one or more habits or patterns of one or more occupants of the premises, one or more inputs received from a device, and/or data received from a radio-based presence sensing arrangement, in order to determine if anyone is present in the premises.

Optionally, the security monitoring system may be configured to store and/or retrieve data relating to one or more security states of the security monitoring system, one or more habits or patterns of one or more occupants, and/or data relating to a current time and/or date.

Optionally, the electrical discharge detector comprises a plug for insertion into an outlet of the electrical wiring.

### BRIEF DESCRIPTION OF THE DRAWINGS

In order to best describe the manner in which the above-described embodiments are implemented, as well as define other advantages and features of the disclosure, a more particular description is provided below and is illustrated in the appended drawings. Understanding that these drawings depict only exemplary embodiments of the invention and are not therefore to be considered to be limiting in scope, the examples will be described and explained with additional specificity and detail through the use of the accompanying drawings in which:
- Fig. 1a: is a schematic view of a security monitoring system according to embodiments;
- Fig1b: is a schematic view of a security monitoring system according to embodiments;
- Fig. 2: is a schematic view of an electrical discharge detector according to embodiments;
- Fig. 3: is a flowchart of an electrical discharge detection method according to embodiments;
- Fig. 4: is a method of operating a security monitoring system according to embodiments;
- Fig. 5: is a method according to embodiments of determining, by a security monitoring system, if anyone is present within a buidling;
- Fig. 6: is a method according to embodiments of determining, by a security monitoring system, if anyone is present within a buidling; and
- Fig. 7: is a method according to embodiments of determining, by a security monitoring system, if anyone is present within a buidling.

Further, in the figures like reference characters designate like or corresponding parts throughout the several figures. The first digit in the reference character denotes the first figure in which the corresponding element or part appears.

### DETAILED DESCRIPTION

Various embodiments of the disclosed methods and arrangements are discussed in detail below. While specific implementations are discussed, it should be understood that this is done for illustration purposes only. A person skilled in the relevant art will recognize that other components, configurations, and steps may be used without parting from the spirit and scope of the claimed invention.

Hereinafter, certain embodiments will be described more fully with reference to the accompanying drawings. It will be apparent to those skilled in the art that various modifications and variations can be made without departing from the inventive concept. Other embodiments will be apparent to those skilled in the art from consideration of the specification and practice disclosed herein. It is to be understood that elements and materials may be substituted for those illustrated and described herein, parts and processes may be reversed or omitted, certain features may be utilized independently, and embodiments or features of embodiments may be combined, all as would be apparent to the skilled person in the art.

The embodiments herein are provided by way of example so that this disclosure will be thorough and complete, and will fully convey the scope of the inventive concept, and that the claims be construed as encompassing all modifications, equivalents and alternatives of the present inventive concept which are apparent to those skilled in the art to which the inventive concept pertains. If nothing else is stated, different embodiments may be combined with each other.

Although reference may be made to directions (e.g. left, right, up, down, upper, lower) as shown in the figures, it will be appreciated that these references are purely for illustrative purposes, and that embodiments are not limited to such directions.

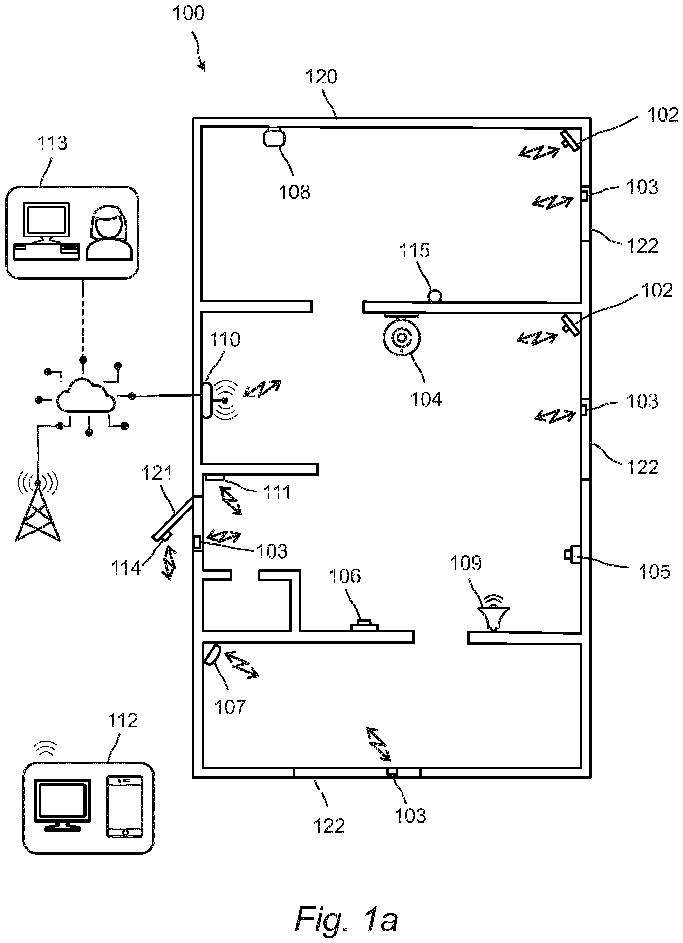

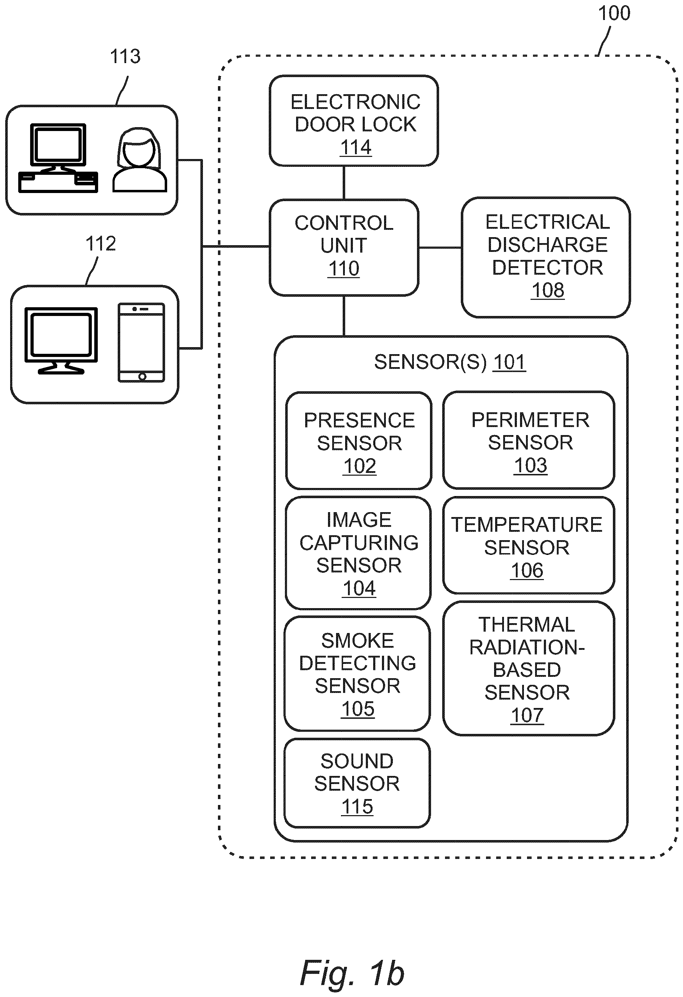

Figs. 1a and 1b show a security monitoring system 100 arranged in premises 120 in the form of a building. The security monitoring system 100 may also be referred to as an alarm system. The premises 120 may be a residential building such as a house or an apartment, and/or a commercial building such as an office building, or the like.

The security monitoring system 100 comprises one or more sensors 101 for monitoring of the premises 120. For example, the sensors 101 may monitor an interior area of the premises 120. While monitoring the premises 120, the sensors 101 may be configured to detect an alarm-incurring event (e.g. an undesirable security or safety event or hazard), such as an intruder and/or a fire.

The security monitoring system 100 may, for instance, include one or more sensors 101 for detecting an intruder entering or moving within the premises. Such sensors 101 may comprise one or more presence sensors 102, one or more perimeter sensors 103, one or more image capturing sensors 104, or a combination of any one or more thereof. Additionally, or alternatively, the security monitoring system 100 may include a sensor 101 for detecting a potential fire within the premises 120. For example, the security monitoring system 100 may comprise a smoke detecting sensor 105 (i.e. a smoke detector) configured to detect smoke inside the premises 120. The security monitoring system 100 may further comprise one or more temperature sensors 106 for monitoring a temperature within the premises 120, and/or one or more other sensors 101 for monitoring one or more parameters and/or characteristics of the premises 120 or its interior.

A presence sensor 102 may be defined as a sensor 101 sensitive to the presence of persons and/or objects within an area monitored by the presence sensor 102. Presence sensors 102 may include motion or passage sensors sensitive to motion or passage of a person and/or object within the premises 120. The presence sensor 102 may thus comprise any type of sensor or detector capable of detecting presence, and/or movement of a person and/or object.

For example, the presence sensor 102 may comprise a thermal radiation-based sensor 107 for detecting an amount of incident thermal radiation, or the like. In particular, the presence sensor 102 may include an infrared sensor such as a thermal-MOS (TMOS) sensor and/or a passive infrared sensor (also referred to as a PIR sensor).

As another example, the presence 102 may comprise a sound sensor 115 such as a microphone configured to monitor and/or detect sounds within the premises 120. It will be appreciated that the sound sensor 115 may be integrated in, or form part of or another component of the security monitoring system. For example, there may be a microphone integrated in the image capturing sensor 104, the input means 111 and/or the control unit 110.

Other examples of presence sensors 102 include optical sensors, visual sensors, thermal sensors, radiation-based sensors and/or image capturing means such as a camera.

A perimeter sensor 103, on the other hand, may be defined as a sensor 101 configured to detect persons and/or objects crossing or breaching a perimeter of the premises 120. Exemplary perimeter sensors 103 include magnetic sensors arranged at windows 122 and/or doors 121, and/or glass breakage sensors (such as a shock sensor) for detecting breakage of e.g. a window 122 or glass door.

In embodiments, the security monitoring system 100 may comprise at least one sensor 101 comprising image capturing means, such as a camera (e.g. a photographic camera), video camera or any other type of type of optical sensing device capable of capturing or acquiring one or more still and/or moving images. Such a sensor 101 may accordingly be referred to as an image capturing sensor 104. The image capturing sensor 104 is configured to capture one or more images of an area of the premises 120 proximate to where it is located. For instance, the image capturing sensor 104 may capture images of the room in which it is located.

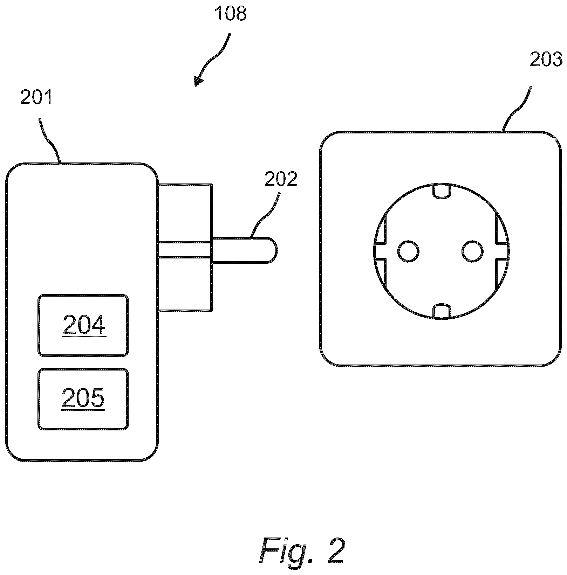

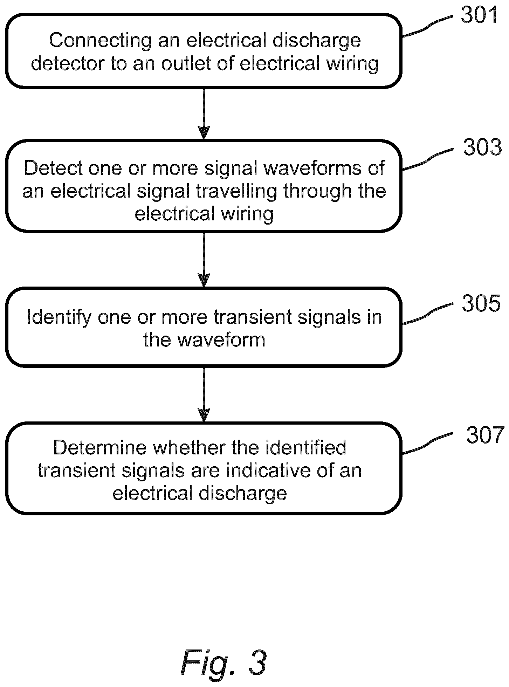

In addition to the above-described sensors 101, the security monitoring system 100 according to embodiments comprises at least one electrical discharge detector 108 for detecting electrical discharges in the electrical wiring of the premises 120. The electrical discharge detector 108 will be described further in relation to Figs. 2 and 3.

The security monitoring system 100 may comprise one or more alarm indicators 109 such as a visual alarm indicator (e.g. a flashing light), an audible alarm indicator (e.g. a siren), or the like, that may be activated in the event of an alarm-incurring event being detected.

The security monitoring system 100 may further comprise a control unit 110 which may also be referred to as a central unit. The control unit 110, which may generally be mains powered, is coupled or connected to the sensors 101 and the electrical discharge detector 108, and is configured to process received signals and determine a response. The sensors 101 and the electrical discharge detector 108 may, for example, be provided with wireless (e.g. via Wi-Fi, radio frequency, or the like) and/or wired communication means for communicating with the control unit 110. In particular, the sensors 101 may be coupled to the control unit 110 using transceivers that may operate in the industrial scientific and medical (ISM) bandwidths, for example a sub-gigahertz bandwidth such as 868 MHz, and the communications may be encrypted preferably using shared secret keys.

The control unit 110 may include a processor and an alert triggering unit for providing an alert signal when the security monitoring system 100 is triggered or set off, e.g. when an alarm-incurring event has occurred.

The control unit 110 may also be connected to input means 111 allowing a user to interact with the control unit 110. The input means 111 may be a keypad or similar, for arming and disarming the sensors 101 so as to arm and disarm the security monitoring system 100. In the illustrated embodiment, the input means 111 is arranged in the vicinity of the entrance door 121. In some embodiments, the input means 111 comprises voice-controlled input means.

The control unit 110 may communicate with one or more user devices 112, which may be almost any kind of electronic device such as a smartphone, tablet, laptop or desktop computer, a smart watch, or even a television. For example, the control unit 110 may communicate with an app or other program installed on such user devices 112 allowing the user to interact with the control unit 110 and/or the security monitoring system 100. The user device 112 may also be loaded with a public land mobile network (PLMN) by means of which the control unit 110 (and/or a remote monitoring centre 113 as will be described later), may communicate with the user device 112. The user device 112, and in particular the app or program installed thereon, may thus form input means 111 to the control unit 110 such that the user can, though the user device 112, instruct the control unit 110 to arm or disarm the security monitoring system 100, or the like. The user device 112 may also provide the user with information relating to a state of the security monitoring system 100 (e.g. if it is in an armed or disarmed state) and/or one or more of its sensors 101. The security monitoring system 100 may accordingly notify the user via the user device(s) 112 if and when the security monitoring system 100 is set off or triggered.

The control unit 110 may further be connected to a remote monitoring centre 113, which is located remotely from the premises 120. The control unit 110 may accordingly be configured to transmit alert signals to the remote monitoring centre 113, where operators (i.e. human operators) and/or computerised systems manage the alert signals and determines an appropriate action. That is, the control unit 110, typically located in the premises 120, is configured to process notifications and signals received from the sensors 101 and/or the electrical discharge detector 108, and to notify the remote monitoring centre 113 of at least some of these signals that are indicative of an alarm-incurring event (e.g. an undesirable security or safety event), depending upon the settings of the system and the nature of the detected events. In such a configuration, the control unit 110 at the installation is effectively acting as a gateway between the sensors 101 and the remote monitoring centre 113.

The control unit 110 may be connected to the remote monitoring centre 113 by wires, such as a telephone line, or by a wireless telecommunications system such as GSM or other radio frequency systems. The connection may also be through the internet or any other suitable network.

Hence, operation of the security monitoring system 100 may be controlled by one or more of: the control unit 110, the remote monitoring centre 113, and a security monitoring app installed on the user device 112. For example, the remote monitoring centre 113, if provided, may receive one or more signals from any of the sensors 101 and/or the electrical discharge detector 108. The remote monitoring station 113 may transmit commands for controlling any one or more of: the arm state of the security monitoring system 100 (e.g. armed or unarmed), commanding a tripped alarm state to be signalled by the security monitoring system 100 (e.g. by triggering one or more alarm indicators 109 to generate alarm noise), commanding operation of one or more functions of the sensors 101 and/or electrical discharge detector 108. Communication with the remote monitoring centre 113 may pass through the control unit 110. In other embodiments without the remote monitoring centre 113, or should communication with the remote monitoring centre 113 be interrupted, operation of the security monitoring system 100 may be controlled by the control unit 110. In yet other embodiments, the control unit 110 may be omitted, and the sensors 101 and/or the electrical discharge detector 108 may instead communicate independently with the remote monitoring centre 113, for example, via wireless communication (such as Cat-M LTE).

Howsoever the communication is implemented, the remote monitoring centre 113 may alert one or more operators of an alarm-incurring event. The one or more operators may monitor communications received from the security monitoring system 100. Thus, the one or more operators may, in response to an alert signal being transmitted, send a patrol unit and/or the emergency services to the premises 120 and/or notify an owner or resident of the premises 120.

The security monitoring system 100 may further include one or more electronic door locks 114 (such as electronic smart locks) for providing and/or controlling a locking mechanism of a door 121. Hence, the locking mechanism at the door 121 may be electrically opened and closed so as to unlock or lock the door 121. The electronic door lock 114 may communicate with the control unit 110 and/or one or more user devices 112, e.g. to transmit instructions from a user to lock or unlock the door 121. Alternatively, additionally, the electronic door lock 114 may be locked/unlocked by placing a key fob or the like in the vicinity of the electronic door lock 114 or an associated key fob panel. The electronic door lock 114 may additionally be configured to transmit information about a state of the electronic door lock 114 to the control unit and/or the user device 112 (e.g. information about whether the electronic door lock 114 is in a locked or unlocked state).

Fig. 2 shows an electrical discharge detector 108 according to embodiments. The electrical discharge detector 108 comprises a detection unit 201 and a plug 202 for connection to an electrical outlet 203 (e.g. a socket) of the electrical wiring of the premises. Hence, the plug 202 is configured to electrically couple the detection unit 201 to the electrical wiring. The detection unit 201 is thus configured to measure an electrical signal of the electrical wiring at the location where the electrical discharge detector 108 is connected.

Here it is noted that the electrical wiring may comprise one or more circuits in a power distribution system within the premises. The electrical wiring may thus be configured to transfer electrical power from a feeder cable (feeding the premises with electrical power) to branch wires or circuits which in turn feed the power to appliances and outlets 203 in the premises 120. Hence, the electrical discharge detector 108 is intended to be connected directly to the electrical wiring by insertion of the plug 202 into a standard electrical outlet 203. The electrical discharge detector 108 may accordingly be installed without the need for an electrician.

The detection unit 201 of the electrical discharge detector 108 may comprise a processing module 204 and a communication module 205. The processing module 204 may comprise signal capturing means for capturing the electrical signals travelling through the electrical wiring as waveform data, a signal converter such as an analog-to-digital signal converter, a signal amplifier, and/or one or more filters for filtering out 50Hz and/or 60Hz signals and/or electrical noise generated by appliances and devices connected to the electrical wiring. The filters and/or amplifiers may be achieved using hardware and/or software.

In some embodiments, at least part of the processing is performed remotely from the electrical discharge detector 108, for example on a server, at the control unit 110, at the remote monitoring centre 113, or the like. That is, the electrical discharge detector 108 may be configured to transmit the measured electrical signal to a remotely located processor which may be configured to process and analyse the received electrical signal.

The communication module 205 may comprise (wired and/or wireless) means for communicating (i.e. transmitting and/or receiving signals) with the central unit 110, the remote monitoring centre 113, one or more user devices 112, and/or the emergency services.

The electrical discharge detector 108 is configured to detect electrical discharges in the electrical wiring of the premises 120. The electrical discharges may also be referred to as electrical arcs or electrical arc faults.

Electrical discharges typically occur when the integrity of an electrical wire or its insulation is compromised. For example, the electrical wire or its insulation may be damaged (e.g. physical damage, and/or water damage), corroded, aged, or the like, or one or more connections between the electrical wire and another electrical component may have come loose. Such damage may lead to sporadic electrical discharges within the wire and/or between the wire and another electrical conductor.

As the electrical discharges continue over time, the damage or erosion to the insulation or other materials surrounding the wire is worsened, increasing the intensity of the electrical discharges. Hence, after sufficient time has passed, the electrical discharges may become high-power, continuous and high-temperature discharges which may eventually result in the ignition of a spark or fire in the material in which the electrical wiring is arranged which is often combustible (e.g. wood and/or insulation in the walls of the premises 120).

It is accordingly important to detect electrical discharges in electrical wiring as early as possible to reduce the risk of a fire. Hence, by detecting electrical discharges, a user (e.g. the occupant of the premises) and/or the emergency services can be alerted to the faulty electrical wiring, hopefully in time to prevent a fire from starting and/or put out a fire at an early stage. The electrical discharge detector 108 may accordingly improve a potential fire safety aspect of the security monitoring system 100.

As the electrical discharges give rise to a sharp electromagnetic impulse (e.g. an impulse of current) that travel through the electrical wiring, the electrical discharge detector 108 can detect the electrical discharges by monitoring the electrical signals travelling through the electrical wiring and identifying any impulses likely to originate from an electrical discharge. The method of detection of electrical discharges will be described in more detail in relation to Fig. 3.

It is noted that the electrical signals captured by the electrical discharge detector 108 includes signals transmitted within, to, and from the full electrical wiring. Thus, a single electrical discharge detector 108 is capable of sensing electrical discharge signals throughout the full electrical wiring, including electrical discharges occurring on other branch circuits of the electrical wiring. This is contrary to techniques using arc-fault circuit interrupters (AFCI), where the AFCI must be installed in each electrical outlet and/or in each electrical wiring circuit in the premises in order to detect electrical discharges on each of the individual branch circuits.

Upon detection of an electrical discharge, the electrical discharge detector 108 may be configured to transmit a signal to the control unit 110. Additionally, or alternatively, the electrical discharge detector 108 may be configured to transmit an alert signal directly to the remote monitoring centre 113, a user device 112, and/or the emergency services.

The electrical discharge detector 108 may additionally be configured to notify an occupant of the premises 120 of the detected electrical discharge. The electrical discharge detector 108 may accordingly comprise one or more notification means for notifying a user. The notification means may comprise a visual notification means (e.g. a flashing light), an audible notification means (e.g. a siren), or the like.

Although references have been made to a single electrical discharge detector 108, it is appreciated that the security monitoring system 100 may comprise a plurality of electrical discharge detectors 108 arranged in different outlets 203 of the electrical wiring. The plurality of electrical discharge detectors 108 may be used in simultaneously and in combination to increase the detection sensitivity. The plurality of electrical discharge detectors 108 may additionally or alternatively work together to provide approximate information on the likely location of the electrical discharges within the electrical wiring.

Fig. 3 shows a method of detecting an electrical discharge by the electrical discharge detector 108 according to embodiments. It will be appreciated that the detection method of Fig. 3 is purely exemplary, and embodiments also include detection of electrical discharges by any other suitable method.

In step 301, the electrical discharge detector 108 is connected to an outlet of the electrical wiring of the premises 120.

In step 303, the electrical discharge detector 108 senses or detects an electrical signal travelling through the electrical wiring of the premises 120. In particular, the electrical discharge detector captures one or more signal waveforms (e.g. voltage and/or current waveforms) generated by electrical activity in or connected to the electrical wiring.

In step 305, the electrical discharge detector 108 identifies one or more transient signals in the waveform. Because electrical discharges involve an impulse change in current (as explained previously), the electrical signal generated or caused by said electrical discharge is transmitted along the electrical wiring which can be identified by the electrical discharge detector 108 as transient signals. Accordingly, the electrical discharge detector 108 is configured to detect a change in the signal waveform data in order to identify one or more transient signals in the waveform. The identification of transient signals may be performed using any known method or process, including but not limited to processes involving binning of sampled waveform data, use of floating thresholds of samples in the waveform data, calculation of derivates and/or maximums, or the like.

In step 307, the electrical discharge detector 108 analyses the identified transient signals to determine whether the identified transient signals are indicative of an electrical discharge. For example, the electrical discharge detector 108 may generate and analyse one or more transient characteristics in dependence on the identified transient signals. The generation of transient characteristics may be performed using any known method or process, including but not limited to, methods involving calculating the average transient amplitude over a full voltage cycle and/or for phase sections within the voltage cycle, calculating the amplitude, pulse width, integral and/or rise time of peaks of the transient, or the like.

In analysing the transient characteristics, the electrical discharge detector 108 may identify one or more electrical discharge indicators in the transient characteristics, for example by comparing the transient characteristics to reference data and characteristics, and/or data associated with previously detected electrical discharges, which may be stored in a memory of the electrical discharge detector 108.

As an example, the electrical discharge detector 108 may reconstruct the signal waveform using the generated transient characteristics and compare the distribution of transients in the reconstructed waveform to an expected or reference transient distribution. Here it is noted that the transient signals generated by an electrical discharge travel along the electrical wiring being reflected at any junction. The signals caused by the electrical discharge experience a delay in returning which is dependent on the length of the wire, as well as exhibiting a phase shift.

Hence, if the comparison shows that the transients occur in phase and/or in a regular or repeatable pattern, the transients are likely a result of (normal) operation of a device or appliance connected to the electrical wiring. Alternatively, if the comparison shows that the transients are out of phase and/or in an irregular pattern, this indicates that the transients are a likely result of one or more electrical discharges.

As another example, the electrical discharge detector 108 may compare the generated transient characteristics to reference characteristics data and/or reference characteristics thresholds using any known or suitable method. For instance, the electrical discharge detector 108 may determine the average peak ratio of transients in phase sections of the voltage cycle close to maximum voltage to transients in phase sections of the voltage cycle close to zero voltage, and compare the determined ratio with a threshold value where, if the ratio is above the threshold value, the transient signals are determined as being indicative of an electrical discharge. As another example, the electrical discharge detector 108 may determine if the number of peaks in the transient exceeds a threshold and/or if the rise time for the one or more of the peaks is greater than a threshold. If so, the transient may be determined to be indicative of an electrical discharge.

In some embodiments, the electrical discharge detector 108 may calculate a likelihood value of an electrical discharge having occurred, for example in dependence on how irregular and/or out of phase the transient signals are and/or how far above/below the characteristics are from one or more thresholds. The likelihood value may then be compared to a threshold value to determine whether an electrical discharge has been detected.

In some embodiments, the analysis of transient characteristics may be improved by machine learning techniques, e.g. for determining appropriate threshold levels and/or appropriate reference data.

Once a transient signal has been determined to be indicative of an electrical discharge, i.e. when a likely electrical discharge has been detected, the electrical discharge detector 108 may transmit a signal to the control unit 110, one or more sensors 101 of the security monitoring system 100, the remote monitoring centre 113, one or more user devices 112, and/or the emergency services. The electrical discharge detector 108 may additionally notify an occupant of the premises 120 of the detected electrical discharge using visual and/or audible notification means.

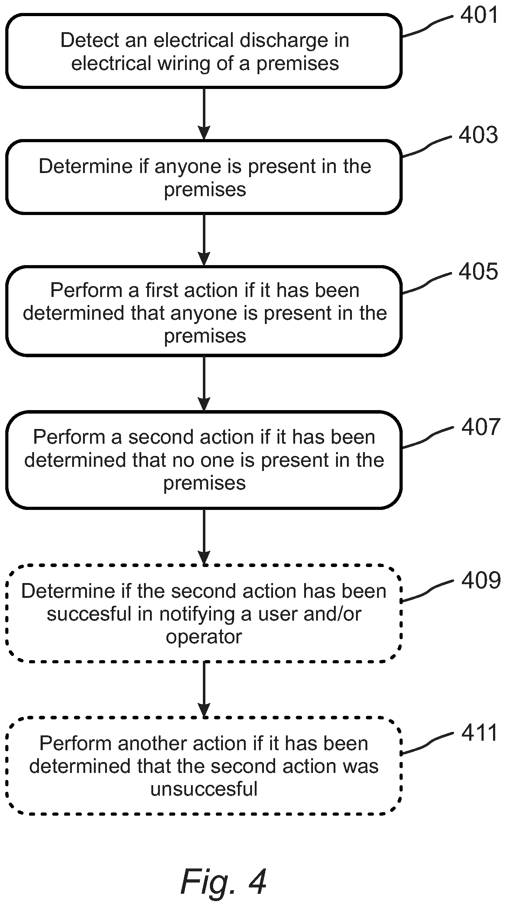

Fig. 4 shows a method of operating the security monitoring system 100 in response to the detection of an electrical discharge by the electrical discharge detector 108. In particular, when an electrical discharge has been detected, the security monitoring system 100 is configured to determine if anyone (e.g. a person such as an occupant or resident, and/or an animal such as a pet) is (physically) present within the premises 120, and to decide a course of action in dependence on whether anyone is present in the premises 120 or not.

In step 401, the electrical discharge detector 108 detects a likely electrical discharge which could be a precursor to a fire. The electrical discharge detector 108 may detect the electrical discharge according to the method of Fig. 3 or any other suitable method. Once an electrical discharge has been detected, the electrical discharge detector 108 transmits a signal to the security monitoring system 100 (e.g. to the control unit 110) and/or the remote monitoring centre 113. Importantly, the electrical discharge detector 108 is configured to be active irrespective of whether the security monitoring system 100 is in an armed or disarmed state (i.e. the electrical discharge detector 108 is substantially always active) and can hence detect electrical discharges that occur at any time (e.g. even if someone is present in the premises 120 and the security monitoring system 100 is disarmed).

In step 403, the security monitoring system 100 determines if anyone is likely to be present in the premises 120. The determination in step 403 may be performed in response to receiving the signal from the electrical discharge detector 108 that an electrical discharge has been detected. Alternatively, the determination may have been made prior to the electrical discharge being detected, for example, not long before the electrical discharge was detected.

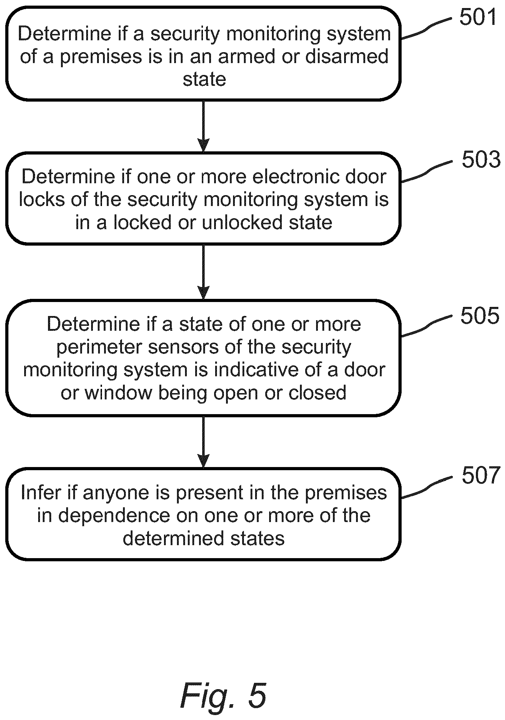

The security monitoring system 100 may determine whether someone is present in the premises 120 by (i) inferring that someone is likely to be present in the premises 120 from a security state of the security monitoring system 100, (ii) detecting the presence of someone in the premises 120 by one or more sensors 101, (iii) receiving input from one or more users about the presence of someone in the premises 120, or a combination thereof. These methods of determining if anyone is present in the premises 120 will be described in more detail in relation to Figs. 5 to 7.

After the determination has been made, the security monitoring system 100 selects an action in dependence on whether anyone is present in the premises 120 or not. In particular, the security monitoring system 100 may decide on a first action if it is determined that there is someone present in the premises 120, and on a second (e.g. different) action if it is determined that no-one is present in the premises 120. In other words, the security monitoring system 100 may select one of the first action and the second action in dependence on the security monitoring system 100 having determined that anyone is present in the premises 120 or not. It will accordingly be appreciated that only one of the steps 405 and 407 may be performed.

In some embodiments, both of steps 405 and step 407 may be performed. For example, if it is determined that no one is present in the premises, the security monitoring system 100 may first select and perform the second action (i.e. step 407). The system may then be configured to wait for a predetermined time, such as one or more hours, after which it repeats the presence determination in step 403. If, upon the repeated presence determination, it is now determined that someone is present in the premises, the system may select and perform the first action (i.e. step 405). On the contrary, if no one is still not present in the premises, the security monitoring system 100 may be configured to again select and perform the second action. The system may also be configured to repeat this sequence of steps one or more times, for example until an occupant returns to the premises and/or the cause of the electrical discharge is resolved.

If the security monitoring system 100 has determined that there is someone present in the premises 120, the security monitoring system 100 performs, in step 405, the first action. To reduce the risk of a catastrophic fire, the first action may include starting one or more alarm indicators 109 such as a siren within the premises 120. Hence, people present in the premises 120 are alerted and can evacuate the premises 120. Additionally, the first action may include notifying the emergency services (e.g. the fire brigade). Hence, any fire caused by the electrical discharge can hopefully be put out at an early stage.

If, instead, the security monitoring system 100 has determined that no one is present in the premises 120, the security monitoring system 100 performs, in step 407, the second action. Because it has been determined that no one is, and/or is likely to be, present in the premises 120, no one is in immediate danger and the second action may accordingly be different to the first action. However, if there is uncertainty as to whether anyone is present in the premises 120, the second action may also include starting one or more alarm indicators 109 such as a siren and/or notifying the emergency services.

In particular, the second action may include (i) altering a sensor state of one or more sensors 101 of the security monitoring system 100, (ii) monitoring the premises 120 (e.g. by one or more activated sensors 101 and/or by an operator at the remote monitoring centre 113 viewing sensor data such as images sent by an image capturing sensor 104), (iii) sending a notification (e.g. a push notification) to a user device 112, (iv) contacting (e.g. calling, for example by an operator at the remote monitoring centre 113) an occupant or resident of the premises 120, (v) notifying and/or contacting a designated person (such as a neighbour or relative), or a combination thereof.

The altering of a sensor state may comprise altering a state of one or more sensors 101 (e.g. one or more sensors 101 monitoring an interior area of the premises 120) of the security monitoring system to a state where an alertness level of the sensor 101 is increased. The one or more sensors 101 that are altered may be any sensor 101 previously described in relation to the security monitoring system 100. In the altered state, the sensors 101 may be configured to provide (enhanced) monitoring of an area (e.g. an interior area) of the premises 120 so as to allow detection of a potential fire (and/or a precursor to a fire) in the premises 120. The altering of a sensor state may include activating a sensor 101, increasing a sensitivity of a sensor 101 and/or setting a sensor 101 to a fire detection mode.

For example, an image capturing sensor 104 (e.g. a sensor 101 comprising a photographic and/or video camera) may be activated and instructed to capture one or more images. The images captured by the image capturing sensor 104 may be transmitted to a user (e.g. to an app on a user device 112) such that the user can view the images to monitor if a potential fire has started in the premises 120. The images may alternatively or additionally be sent to the remote monitoring centre 113 for visual monitoring of the premises 120. For instance, an operator at the remote monitoring centre 113 may monitor the images to see if a potential fire has started and/or an image analyser may be used to analyse the images to determine if a potential fire has started.

As another example, a thermal radiation-based sensor 107 (such as an infrared sensor, e.g. PIR sensor) may be activated or instructed to enter a fire detection mode. The thermal radiation-based sensor 107 may accordingly be used to monitor an amount an incident infrared light (or other thermal radiation) which may be indicative of whether a potential fire has started. The thermal radiation-based sensor 107 may, for example, compare the amount of incident infrared light to a reference or threshold amount, in order to determine if the amount of incident infrared light has increased in a way indicative of a potential fire having started within the premises 120. Alternatively, an operator at the remote monitoring centre 113 may monitor the data from the thermal radiation-based sensor.

Similarly, a temperature sensor 106 may be activated to monitor the temperature within the premises 120. The temperature sensor 106 may be configured to continuously monitor a temperature inside the premises 120 so as to detect if and when the temperature increases in a way consistent with or indicative of a potential fire having started within the premises 120.

As yet another example, a sensitivity level of a smoke detecting sensor 105 (which is generally always active) may be altered such that the smoke detecting sensor 105 has an increased sensitivity to smoke. For example, an alert triggering threshold for triggering an alarm may be decreased. Hence, the smoke detecting sensor 105 may provide an alert signal even if only a small amount of smoke is detected.

Hence, by altering the sensor state, the alertness level of the security monitoring system 100 is increased, and the system may monitor the premises 120 to detect if a potential fire breaks out.

The method may comprise an optional step 409 where the system, after the second action has been performed in step 407, determines if the second action has been successful, e.g. has been successful in notifying and/or contacting a user and/or operator. For example, the system may, in step 409, determine if a user (e.g. an occupant, resident, and/or designated person) has been notified by the second action. For instance, the system may determine if the user has answered the call from the remote monitoring centre 113, if the user has opened the push notification sent to the user device 112 (e.g. a read receipt may be sent from the user device 112 once the user opens the push notification and/or the app). As another example, the system may, in step 409, determine if an operator at the remote monitoring centre 113 has opened or interacted with sensor data from one or more activated sensors 101.

If the system determines that the second action has not been successful (e.g. if a user has not answered the call and/or opened the push notification within a predetermined time), the system may, in step 411, repeat step 407 (e.g. by calling the user again and/or calling a different telephone number associated with the same or another user) and/or take another action such as starting an alarm indicator 109 in the premises 120 and/or notifying the emergency services.

The method of Fig. 4 thus allows the security monitoring system to adjust a level of urgency in its response to a detected electrical discharge in dependence on whether anyone is present in the premises or not.

Fig. 5 is a method of determining if someone is present in the premises 120. Accordingly, the determination in step 403 of Fig. 4 may comprise one or more of steps 501 to 507.

In the method of Fig. 5, the security monitoring system 100 is configured to infer whether anyone is present in the premises 120 from one or more security states of the security monitoring system 100. In particular, the security states may comprise an armed or disarmed state of the security monitoring system 100, a locked or unlocked state of one or more electronic door locks 114, and/or a state of one or more perimeter sensors 103 indicating that a corresponding door 121 or window 122 is opened or closed.

Thus, if the security state indicates that the premises 120 is not protected or secured (e.g. if a window 122 or door 121 is open, if the security monitoring system 100 is disarmed, and/or if an electronic door lock 114 is unlocked), the security monitoring system 100 may infer that someone is present inside the premises 120. It is noted that the control unit 110 may be configured to store the present security state(s) of the security monitoring system 100 such that the security monitoring system 100 can request and/or obtain information about current security state(s).

In step 501, the security monitoring system 100 determines if the system is in an armed, disarmed state, or partially armed state (e.g. a perimeter is armed but not an interior of the premises 120, and/or only a part of the interior being armed). The security monitoring system 100 may then infer if anyone is present in the premises 120 or not in dependence on the determined state.

If the security monitoring system 100 is disarmed, it may be inferred or assumed that someone is likely to be present in the premises 120 (noting that it is safer to incorrectly assume someone is present in the premises 120 than to incorrectly assume no one is present in the premises 120). Similarly, if the security monitoring system 100 is armed (e.g. both perimeter sensors 103 and interior sensors such as presence sensors 102 being in an armed state), it may be inferred that no one is present in the premises 120. If the security monitoring system 100, however, is in a partially armed state (e.g. if perimeter sensors 103 are armed but interior sensors such as presence sensors 102 are disarmed), it may only be assumed or inferred that someone is present in the premises 120 or that the determination in step 501 is inconclusive. For example, it is common for the security monitoring system 100 to be in a partially armed state when people in the premises 120 are sleeping such that they are alerted to any intruders breaking through the perimeter but may still move within the premises 120 without triggering the alarm.

In some embodiments, step 501 comprises determining whether interior sensors (e.g. presence sensors 102, thermal sensors, motion sensors) of the security monitoring system 100 are in an armed or disarmed state.

In step 503, the security monitoring system 100 determines if one or more electronic door locks 114 are in a locked or unlocked state, i.e. if the door 121 fitted with the electronic door lock 114 is locked or unlocked. The security monitoring system 100 may then infer if anyone is present in the premises 120 or not in dependence on the determined state. In particular, it may be inferred from an electronic door lock 114 in an unlocked state, that someone is likely to be present in the premises 120. It is noted, however, that no useful conclusion can be inferred if the electronic door lock 114 is locked, because a user may lock their door 121 even if they are at home and present in the premises 120.

In step 505, the security monitoring system 100 determines if a state of one or more perimeter sensors 103 indicates that a corresponding door 121 or window 122 is open or closed. For example, the security monitoring system 100 can determine whether a perimeter sensor 103 in the form of a magnetic sensor registers magnetic contact thus indicating that the door 121 or window 122 is closed, or the opposite.

The security monitoring system 100 may then infer if anyone is present in the premises 120 or not in dependence on the determined state. In particular, the security monitoring system 100 may infer that someone is present in the premises 120 if the perimeter sensor state indicates that the door 121 or window 122 is open. It is again noted, however, that no useful conclusion can be inferred if the perimeter sensor 103 indicates that a door 121 or window 122 is closed, because a user may close their door(s) 121 and/or window(s) 122 even if they are at home and present in the premises 120.

In step 507, the security monitoring system 100 determines whether anyone is likely to be present in the premises 120 based on the inferred information from one or more of steps 501 to 505. For example, the security monitoring system 100 may determine that someone is present in the premises 120 if it has been inferred that someone is present in the premises 120 in at least one of steps 501 to 505.

Alternatively, or additionally, the security monitoring system 100 may assume that someone is present in the premises 120 if none of the steps 501 to 505 conclusively infers that no one is present in the premises 120.

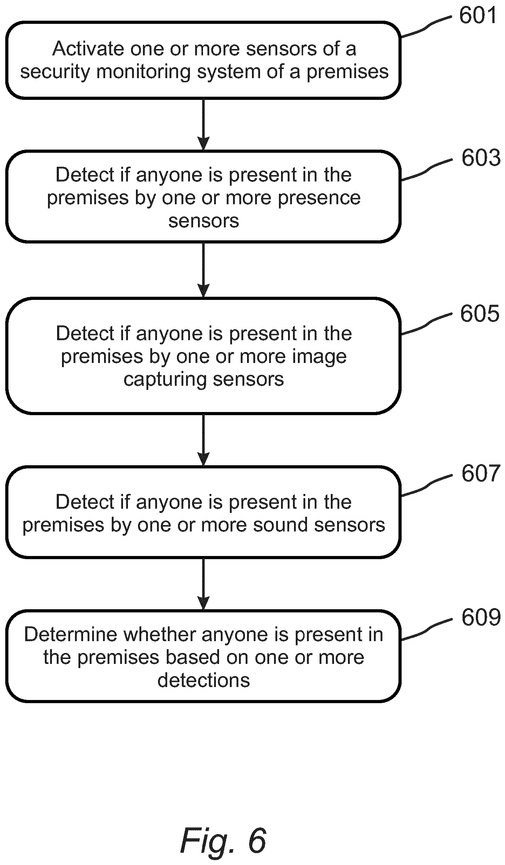

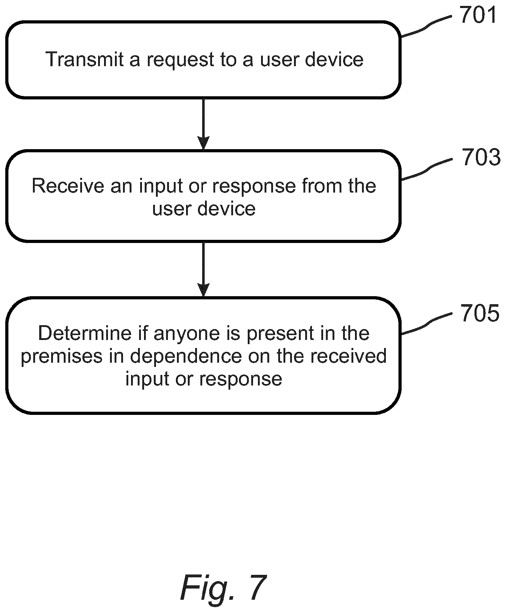

Alternatively, the security monitoring system 100 may, if none of the steps 501 to 505 provide a useful conclusion (e.g. if none of the steps infer that anyone is present and/or none of the steps infer that no one is present), perform another method (e.g. the one or more of the methods of Fig. 6 and 7) to determine if someone is present in the premises 120.

Yet as another alternative, if the security monitoring system 100 may assume that someone is present in the premises 120, if the system based on steps 501 to 505 is uncertain, or if the information received in steps 501 to 505 is inconclusive. Again it is noted that it is safer to incorrectly assume someone is present in the premises 120 than to incorrectly assume no one is present in the premises 120.

It is noted that the method of Fig. 5 may comprise only one of steps 501 to 505, or a combination of at least some of the steps 501 to 505. In some embodiments, the security monitoring system 100 is configured to perform at least two, and preferably all, of steps 501 to 505.

Fig. 6 is another method of determining if anyone is present in the premises 120. Accordingly, the determination in step 403 of Fig. 4 may comprise one or more of steps 601 to 609. It will be appreciated that the method of Fig. 6 may be performed separately from, or in combination with, the method of Fig. 5.

In the method of Fig. 6, the security monitoring system 100 is configured to detect if anyone is present in the premises 120 using one or more sensors 101 of the security monitoring system 100.

In step 601, the security monitoring system 100 activates one or more sensors 101 suitable for detecting presence of anyone in the premises 120. In particular, one or more presence sensors 102, one or more image capturing sensors 104 and/or one or more sound sensors 115 (such as microphones) may be activated. The security monitoring system 100 may accordingly, by activating the sensor(s) 101, detect presence even if the system 100 is in a disarmed state in which the sensors 101 are not normally active.

Of course, it will be appreciated that if the sensor(s) 101 are already activated, e.g. if the security monitoring system 100 is in an armed state, step 601 may be omitted.

In step 603, one or more (activated) presence sensors 102 (e.g. one or more thermal sensors, one or more thermal radiation-based sensors 107, one or more infrared sensors, one or more PIR sensors, one or more image capturing sensors 104, and/or one or more motion sensors) monitor an area of the premises 120 to detect if anyone is present in the premises 120. The detection may be made using any known presence sensor according to any known method of detecting presence by such a presence sensor. In particular, the presence detection may be performed using an infrared sensor, such as a PIR sensor, in dependence on an incident amount of infrared light.

In step 605, which may be performed in addition to (e.g. simultaneously with, before and/or after) step 603, or as an alternative to step 603, one or more images from an image capturing sensor 104 are monitored to detect if anyone is present in the premises 120.

The one or more images may be (still and/or moving) images previously captured by the image capturing sensor 104 and/or new (still and/or moving) images taken in response to a request from the security monitoring system 100. The images may be monitored by an operator at the remote monitoring centre 113, and/or may be analysed by an image analyser configured to detect human or animal-like objects.

In some embodiments, information relating to the presence of anyone in the premises 120 may be inferred from the images even if the images do not directly show a person or animal. As an example, the presence may be inferred from a lighting amount in the images. For instance, the security monitoring system may infer presence if the lighting amount is inconsistent with a typical (or reference) lighting amount associated with the time of day. As an example, if the images are light (e.g. lighter than a reference image) and it can be determined that a time of day corresponds to nighttime, it may be inferred that a lamp or other lighting device is turned on within the premises 120 meaning that someone is likely to be present in the premises 120.

In step 607, which may be performed in addition to step 603 and/or 605, or as an alternative to step 603 and/or 605, a sound sensor 115 monitors sounds in the premises 120. The sound sensor 115 can accordingly detect presence of someone in the premises 120 (or at least infer presence of someone in the premises 120) if sound is detected.

It is noted that the method of Fig. 6 may comprise only one of steps 603, 605 and 607, or a combination of steps 603, 605 and/or 607.

In step 609, the security monitoring system 100 determines whether anyone is likely to be present in the premises 120 based on detections in one or more of steps 603 to 607. For example, it may be determined that someone is present in the premises 120 if at least one of steps 603 to 607 detects presence. If the security monitoring system 100 cannot determine whether anyone is present in the premises 120, and/or if the detection in steps 603 to 607 is inconclusive, the security monitoring system 100 may perform another method (e.g. the one or more of the methods of Fig. 5 and 7) to determine if someone is present in the premises 120.

Alternatively, or additionally, to the method of Fig. 6, presence may be detected by a radio-based presence sensing arrangement which may or may not be part of the security monitoring system 100. For example, one or more devices of the security monitoring system 100, such as the control unit and/or one or more sensors 101, may form node(s) of the radio-based presence sensing arrangement. Alternatively, the radio-based presence sensing arrangement may be separate from the security monitoring system 100 but connected thereto to allow communication between the radio-based presence sensing arrangement and the security monitoring system 100.

The radio-based presence sensing arrangement may be configured to detect perturbations in radio signals (e.g. Wi-Fi signals) transmitted and/or received by one or more nodes of the radio-based presence sensing arrangement. In particular, the radio-based presence sensing arrangement may comprise a plurality of nodes between which radio signals are transmitted. Because the transmitted signals will be affected by the environment (e.g. a space or volume of the premises) through which they are transmitted, the presence of a person (or other object) in the relevant space of the premises will cause perturbations in the transmitted radio signals which may be identified to detect the presence of anyone in the relevant space of the premises. An example of such a radio-based presence sensing arrangement is described in WO2023/126426A1 which is incorporated herein by reference in its entirety.

Fig. 7 is yet another method of determining if someone is present in the premises 120. Accordingly, the determination in step 403 of Fig. 4 may comprise one or more of steps 701 to 705. It will be appreciated that the method of Fig. 7 may be performed separately from, or in combination with, the methods of Figs. 5 and/or 6.

In the method of Fig. 7, the security monitoring system 100 is configured to request a user (e.g. an occupant or resident of the premises 120) to confirm if anyone is present in the premises 120. In particular, the method of Fig. 7 comprises one or more of the following steps.

In step 701, the security monitoring system 100 transmits a request to one or more user devices 112 associated with an occupant or resident of the premises 120. In particular, the request may be in the form of a push notification to the security system app installed on the user device 112. The push notification and/or the app may allow the user to input confirmation of whether the user and/or any other person or animal is present in the premises 120. Alternatively, the request may take the form of a phone call from the remote monitoring centre 113 to a phone number associated with an occupant or resident of the premises 120.

In step 703, the security monitoring system 100 receives an input or response from the user in response to the transmitted request. The input or response may comprise a confirmation from the user whether anyone is present in the premises 120 or not. The input or response from the user may additionally or alternatively inform the security monitoring system 100 that a second request should be transmitted to an additional user (e.g. if another user is better placed to know whether anyone is present in the premises 120).

In step 705, the security monitoring system 100 determines whether anyone is present in the premises 120 in dependence on the input or response received from the user.

If the user does not respond to the request within a predetermined time period, the security management system 100 may assume that someone is present in the premises 120 and/or perform another method (e.g. the one or more of the methods of Fig. 5 and 6) to determine if someone is present in the premises 120.

In some embodiments, the presence determination may alternatively, or additionally, be performed in dependence on a time and/or date (e.g. which weekday it is) and typical habits or patterns of the occupant(s) of the premises. In particular, the security monitoring system may be configured to determine or retrieve a time of day and infer presence in dependence on the time and/or date and typical habits of one or more occupants of the premises. The determination of the time and/or date may include receiving the time and/or date from a device (e.g. a device of the security monitoring system), such as a control unit, one or more sensors or any other device programmed with the time and/or date.

Furthermore, the security monitoring system may know one or more habits or patterns of occupant(s) (e.g. that the occupant(s) always leaves the premises at certain times). This may be known (i) from typical patterns of when the user arms/disarms the security monitoring system, (ii) from typical patterns of when a sensor (e.g. a doorbell camera and/or a perimeter sensor) notices that the occupant leaves/enters the premises, (iii) from typical patterns of when a radio-based presence sensing arrangement notices when an occupant is present in one or more areas of the premises, or the like. Hence, if the system knows that an occupant is always away from the premises at certain times (say, for a couple of hours in the evening), it can infer that the no one is present at the premises during that time of day. Similarly, if the system knows that an occupant is typically present at the premises at certain times, it can infer that someone is likely to be present in the premises at that time of day.

As already mentioned, the previously described methods (including the methods of Figs. 5 to 7) may be performed separately or in combination. For example, the security monitoring system 100 may initially be configured to perform one of the methods (e.g. one of the methods in Figs. 5 to 7) of determining if anyone is present in the premises 120, and, if necessary, one or more of the remaining methods may be subsequently performed. Alternatively, the security monitoring system 100 may be configured to perform two or more of the methods simultaneously to increase the speed of determination. By combining two or more of the methods of determining if anyone is present in the premises 120, an accuracy of said determination is improved. It will also be appreciated that the methods described are purely exemplary, and the determination of whether anyone is present in the premises 120 or not may be performed by any suitable method.

The various embodiments described above are provided by way of illustration only and should not be construed to limit the invention. For example, the principles herein may be applied to any alarm system or security monitoring system. Those skilled in the art will readily recognize various modifications and changes that may be made to the present invention without following the example embodiments and applications illustrated and described herein, and without departing from the scope of the present disclosure.

Throughout this specification, the word "may" is used in a permissive sense (i.e. meaning having the potential to), rather than in the mandatory sense (i.e. meaning must).

Throughout this specification, the words "comprise", "include", and variations of the words, such as "comprising" and "comprises", "including", "includes", do not exclude other elements or steps.

As used throughout this specification, the singular forms "a", "an", and "the", include plural referents unless explicitly indicated otherwise. Thus, for example, reference to "an" element includes a combination of two or more elements, notwithstanding use of other terms and phrases for one or more elements, such as "one or more" or "at least one".

The term "or" is, unless indicated otherwise, non-exclusive, i.e. encompassing both "and" and "or". For example, the feature "A or B" includes feature "A", feature "B" and feature "A and B".

Unless otherwise indicated, statements that one value or action is "based on", "in response to" and/or "in dependence on" another condition or value or action, encompass both instances in which the condition or value or action is the sole factor and instances where the condition or value or action is one factor among a plurality of factors.

Unless otherwise indicated, statements that "each" instance of some collection have some property should not be read to exclude cases where some otherwise identical or similar members of a larger collection do not have the property, i.e. each does not necessarily mean each and every.

## Claims

1. A method of operating a security monitoring system of a premises, the method comprising:
detecting, by an electrical discharge detector of the security monitoring system, an electrical discharge in electrical wiring of the premises;
determining if anyone is present in the premises;
selecting one of a first action and a second action in dependence on the determination, wherein the first action is selected if it is determined that someone is present, and the second action is selected if it is determined that no one is present; and
performing one of the first and second actions in dependence on the selection.

2. The method according to claim 1, wherein the first action includes starting an alarm indicator in the premises and/or notifying emergency services.

3. The method according to claim 1 or 2, wherein the second action includes:
altering a sensor state of one or more sensors of the security monitoring system,
monitoring the premises by one or more sensors of the security monitoring system,
sending a notification to a device, and/or
contacting a person associated with the premises and/or
notifying a remote monitoring centre.

4. The method according to any preceding claim, wherein the step of determining if anyone is present in the premises comprises:
inferring the presence from one or more security states of the security monitoring system, and/or
detecting the presence by one or more sensors of the security monitoring system, and/or
detecting the presence by a radio-based presence sensing arrangement, and/or
inferring the presence in dependence on a time and/or date and one or more typical habits or an occupant of the premises, and/or
determining the presence in dependence on an input from a user.

5. The method according to any preceding claim, wherein the step of determining the presence comprises inferring the presence from one or more security states of the security monitoring system, wherein the security states comprise any one or more of:
an armed or disarmed state of the security monitoring system,
a locked or unlocked state of one or more electronic door locks of the security monitoring system, and
a state of one or more perimeter sensors indicating that a door or window is open or closed.

6. The method according to claim 5, wherein the method further comprises determining that someone is present if at least one of the security states infers presence.

7. The method according to any preceding claim, wherein the step of determining the presence comprises detecting a presence by one or more sensors of the security monitoring system, wherein the one or more sensors comprises any one or more of: a presence sensor, a radiation-based sensor, an infrared sensor, a passive infrared sensor, a motion sensor, a photosensor, a temperature sensor, a shock sensor, a sound sensor, and/or an image capturing sensor.

8. The method according to claim 7, wherein the step of detecting the presence comprises activating the one or more sensors and/or monitoring the premises by the one or more sensors.

9. The method according to claim 7 or 8, wherein the one or more sensors comprise an image capturing sensor, wherein the method further comprises:
acquiring an image from the image capturing sensor,
determining a lighting amount in the premises,
determining a time of day, and
inferring presence in dependence on the time of day.

10. The method according to any preceding claim, wherein the step of determining the presence comprises determining the presence in dependence on an input from a user, wherein the method further comprises:
transmitting a request to one or more devices,
receiving an input from at least one of the devices in response to the request, and
determining presence in dependence on the received input.

11. The method according to claim 10, wherein the method further comprises:
if no input has been received within a predetermined time period, transmitting a second request to one or more devices.

12. The method according to any preceding claim, wherein the electrical discharge detector comprises a plug inserted into an outlet of the electrical wiring.

13. The method according to any preceding claim, wherein the step of detecting the electrical discharge comprises:
measuring an electrical signal waveform of the electrical wiring;
identifying one or more transient signals within the waveform; and
determining an occurrence of the electrical discharge in dependence on transient characteristics of the one or more transient signals.

14. A security monitoring system for monitoring of a premises, the security monitoring system comprising:
at least one electrical discharge detector configured to be connected to an outlet of electrical wiring in the premises, wherein the electrical discharge detector is configured to detect an electrical discharge in the electrical wiring; and
at least one presence inferring means configured to infer or detect if anyone is present at the premises.

15. The security monitoring system according to claim 14, wherein the security monitoring system is configured to perform the method according to any of claims 1 to 13.
